# DEMANDE DE BREVET EUROPEEN

(11) **EP 2 096 681 A1**
(43) Date de publication de la demande: **02.09.2009**
(21) Numéro de dépôt: 08300119.8
(22) Date de dépôt: 27.02.2008
(51) Int. Cl.: H01L 31/05, H01R 9/24

(54) **Dispositif de connexion électrique externe des cellules électriquement actives d'un panneau électriquement actif, telles que les cellules génératrices d'électricité d'un panneau photovoltaïque**

(71) Demandeur: Arcelormittal-Stainless & Nickel, 93200 Saint Denis (FR); Multi Contact France, 68220 Hesingue (FR); Jautard, Yves, 66500 Ria Sirach (FR)
(72) Inventeur: Jautard, Yves, 66500, RIA SIRACH (FR); Hengel, Christian, 68720, HOCHSTATT (FR); Reyal, Jean-Pierre, 95610, ERAGNY (FR)
(74) Mandataire: Jacobson, Claude

(57) **Abrégé**

Dispositif de connexion électrique externe d'un panneau photovoltaïque (1), comprenant un connecteur mâle (100) disposé sur la tranche du panneau photovoltaïque (1), comportant une pluralité de bandelettes de connexion externes (5, 5', 5") reliées électriquement aux cellules génératrices d'électricité, une barrette d'interconnexion électrique des bandelettes externes (160), comportant des moyens de jonction électrique (165) avec les bandelettes de connexion externe, et des circuits électriques adaptés à l'interconnexion des cellules génératrices d'électricité, un premier connecteur extérieur (180) comportant un moyen (181) de jonction électrique avec une première bandelette de connexion externe, et un deuxième connecteur extérieur (190) comportant un moyen (191) de jonction électrique avec une deuxième bandelette de connexion externe et un moyen de maintien (140) de l'assemblage du connecteur mâle (100), de la barrette d'interconnexion (160), du premier (180) et du deuxième (190) connecteur externe.

## Description

La présente invention est relative à un dispositif de connexion électrique externe des cellules génératrices d'électricité d'un panneau photovoltaïque.

Afin d'équiper des bâtiments tels que des maisons, de générateurs d'électricité utilisant l'énergie solaire, on dispose, par exemple sur le toit de ces bâtiments, des ensembles de panneaux constitués d'une pluralité de cellules photovoltaïques. Ces panneaux sont constitués en général d'un empilage de diverses couches de verre, de silicium, de conducteurs et de polymères. Les cellules de silicium, généralement carrées, ont une dimension pouvant atteindre 200 mm de côté. Ces cellules, qui constituent des générateurs d'électricité, sont assemblées en série puis collées entre deux feuilles de verre, ou entre une feuille de verre et diverses couches de polymère. A titre d'exemple, un module de tension nominale de 12V est généralement composé par la mise en série de 36 (2x18) cellules monocristallines ou polycristallines. Ces assemblages de 36 cellules sont ensuite assemblés en parallèle. Dans le cas d'un module de 24V, on utilise alors 72 cellules de silicium.

De tels panneaux ou modules ont une face avant constituée de verre, dirigée vers le soleil, destinée à faire passer le rayonnement de façon à ce qu'il puisse interagir avec les cellules de silicium et générer de l'électricité. Ils ont également une face arrière qui peut être soit opaque et constituée d'un empilement complexe de polymères, soit être transparente et, par exemple, être constituée d'une plaque de verre. Ces modules ou panneaux photovoltaïques sont disposés sur des cadres qui permettent de les fixer sur les toits. En outre, ils sont connectés entre eux ainsi qu'avec un circuit de distribution extérieur destiné à alimenter les utilisations de l'électricité.

En général, les connexions se font à l'arrière des panneaux photovoltaïques par l'intermédiaire de faisceaux de câble s'étendant sous les panneaux.

Lorsque les panneaux photovoltaïques sont transparents, ces faisceaux de câble sont particulièrement disgracieux ce qui présente un inconvénient notamment lorsque les panneaux sont destinés à être placés en façade de bâtiment. En effet, de tels panneaux transparents peuvent être utilisés comme moyen d'ornementation et la présence de faisceaux de câble à l'arrière visibles en transparence rend ces panneaux inadaptés à un tel usage.

Le but de la présente invention est de remédier à ces inconvénients en proposant un moyen universel permettant de connecter sur un circuit extérieur des cellules génératrices d'électricité d'un panneau photovoltaïque, et qui satisfait au moins un des objectifs ci-dessous:
- Ne pas occulter l'une des faces du panneau lorsque celui-ci est transparent.
- Permettre la connectique sur tranche du panneau photovoltaïque quel que soit le type de panneau, transparent ou opaque.
- Permettre l'intervention sur la connexion électrique des panneaux tout en garantissant la sécurité par IP2X des intervenants, quel que soit le type de panneau photovoltaïque, c'est-à-dire y compris les panneaux fabriqués actuellement (Norme CEI 529, NF EN 60529).

A cet effet, l'invention a pour objet un dispositif de connexion électrique externe des cellules électriquement actives d'un panneau électriquement actif, telles que les cellules génératrices d'électricité d'un panneau photovoltaïque, qui comprend :
- un connecteur mâle disposé sur la tranche du panneau photovoltaïque, comportant une pluralité de bandelettes de connexion externes reliées électriquement aux cellules génératrices d'électricité,
- une barrette d'interconnexion électrique des bandelettes externes, comportant des moyens de jonction électrique avec les bandelettes de connexion externe reliés entre eux par des circuits électriques adaptés à l'interconnexion des cellules génératrices d'électricité,
- un premier connecteur extérieur comportant un moyen de jonction électrique avec une bandelette de connexion externe reliée à une première polarité des cellules génératrices d'électricité,
- un deuxième connecteur extérieur comportant un moyen de jonction électrique avec une bandelette de connexion externe reliée à une deuxième polarité de cellules génératrices d'électricité, et
- un moyen de maintien de l'assemblage du connecteur mâle, de la barrette d'interconnexion, du premier et du deuxième connecteur externe.

De préférence, le connecteur mâle comprend une barrette support des bandelettes de connexion externe comportant une lame s'étendant à l'extérieur du panneau photovoltaïque, et les bandelettes de connexion externe sont enroulées autour de la lame.

De préférence, le connecteur mâle comprend, en outre, une entretoise comportant des créneaux destinés à recevoir les bandelettes de connexion externe, et la barrette support comprend une tête adaptée pour s'emboîter sur l'entretoise.

De préférence, l'entretoise est collée sur la tranche du panneau photovoltaïque.

De préférence, la lame s'étend à l'extérieur du panneau photovoltaïque, perpendiculairement à la surface du panneau photovoltaïque.

Le moyen de maintien de l'assemblage est, par exemple, un manchon creux comportant une ouverture supérieure dans laquelle la barrette support des bandelettes de connexion externe est emmanchée. La périphérie de l'ouverture supérieure et de la partie de barrette destinée à s'emboîter dans l'ouverture supérieure sont conformés de façon à assurer l'étanchéité de la jonction du manchon et de la barrette.

La barrette comporte par exemple un bourrelet périphérique destiné à assurer l'étanchéité de la jonction avec le manchon.

Le manchon et la barrette peuvent être collés entre eux.

De préférence, Le manchon comporte à chacune de ses extrémités un passage pour un connecteur extérieur.

Le passage pour un connecteur extérieur est, par exemple, une échancrure dont la périphérie comporte une gorge.

De préférence, chaque connecteur extérieur comporte une palette de jonction électrique avec une bandelette de connexion externe, reliée électriquement à une cosse de connexion extérieure, et un manchon en matériau polymère souple adapté pour s'emboîter dans le passage pour connecteur extérieur du manchon de façon à constituer une fermeture étanche du passage.

De préférence, la cosse de connexion extérieure d'un connecteur extérieur est une cosse mâle et la cosse de connexion extérieure de l'autre connecteur extérieur est une cosse femelle.

La palette de jonction d'au moins un connecteur extérieur peut être soudée par brasage sur une bandelette de connexion externe.

De préférence, la barrette d'interconnexion électrique comprend une lame comportant des patins de jonction électrique avec les bandelettes externes, enfichable de façon réversible dans une ouverture inférieure du manchon creux.

De préférence, la périphérie de l'ouverture inférieure du manchon et la partie de la barrette d'interconnexion destinée à s'emboîter dans le manchon sont conformés de façon à assurer l'étanchéité de la jonction du manchon et de la barrette d'interconnexion.

De préférence, le connecteur mâle, la barrette d'interconnexion et le moyen de maintien de l'assemblage comportent au moins une pièce en matière plastique.

Les circuits électriques adaptés pour l'interconnexion des cellules peuvent comporter des diodes de by passage et des connexions de mise en parallèle ou en série de cellules génératrices d'électricité.

De préférence, les bandelettes de connexion externes sont des rubans conducteurs partiellement isolés par des couches d'isolation telles que des couches d'émail.

L'invention concerne, enfin, un panneau électriquement actif comportant au moins une cellule électriquement active, équipé d'un connecteur externe selon l'invention.

L'invention concerne également un panneau électriquement actif tel qu'un panneau photovoltaïque monté dans un cadre support comprenant quatre montants creux tubulaires et des moyens de connexion externe du panneau électriquement actif, dont les moyens de connexion externe sont selon l'invention et sont disposés à l'intérieur des parties tubulaires creuses des montants du cadre support.

De préférence, le moyen de connexion externe comprend au moins une cosse de connexion extérieure mâle et une cosse de connexion extérieure femelle s'étendant à l'extérieur du cadre et disposés de telle sorte que les panneaux électriquement actifs de deux cadres adjacents peuvent être connectés entre eux par emboîtement d'une cosse mâle d'un cadre et d'une cosse femelle de l'autre cadre.

De préférence, le cadre est constitué d'au moins une bande métallique découpée, et mise en forme par pliage.

De préférence, le cadre est constitué de quatre montants séparés assemblés entre eux.

L'invention va maintenant être décrite de façon plus précise mais non limitative en regard des figures annexées, dans lesquelles :
- la figure 1 est une représentation schématique des circuits de connexion d'un ensemble de cellules génératrices d'électricité d'un panneau photovoltaïque,
- la figure 2 est une vue avec arrachements partiels de la connexion vers l'extérieur d'une polarité d'une cellule génératrice d'électricité d'un panneau photovoltaïque,
- la figure 3 est une vue éclatée d'un dispositif de connexion électrique externe des cellules génératrices d'électricité d'un panneau photovoltaïque,
- la figure 4 est une vue en perspective partielle de bandelettes de connexion externes de cellules génératrices d'électricité d'un panneau photovoltaïque débouchant sur la tranche du panneau photovoltaïque,
- la figure 5 est une vue en coupe dans une position intermédiaire de montage d'un connecteur mâle des cellules génératrices d'électricité d'un panneau photovoltaïque,
- la figure 6 est une vue en coupe du connecteur mâle de la figure 5, en position d'utilisation,
- la figure 7 est une vue schématique d'une barrette d'interconnexion électrique des bandelettes externes de connexion des cellules d'électricité d'un panneau photovoltaïque,
- la figure 8 est une vue en coupe d'un dispositif de connexion externe d'un panneau photovoltaïque inséré dans un cadre support de panneau photovoltaïque,
- la figure 9 est une vue en perspective avec arrachements, d'un connecteur extérieur mâle inséré dans un cadre support d'un panneau photovoltaïque,
- la figure 10 est une vue de côté d'un connecteur extérieur femelle inséré dans un cadre support de panneau photovoltaïque,
- la figure 11 est une vue de dessus d'un panneau photovoltaïque disposé dans un cadre support comprenant des connecteurs,
- la figure 12 est une vue en coupe d'un montant du cadre comportant une cosse de connexion extérieure dans une première phase de montage,
- la figure 13 est une vue en coupe d'un montant du cadre comportant une entretoise dans la première phase de montage,
- la figure 14 est une vue en coupe du montant de la figure 12 dans une deuxième phase de montage,
- les figures 15, 16 et 17 sont des vues en coupe latérale d'un cadre de support d'un panneau photovoltaïque dans trois phases de montage successives.

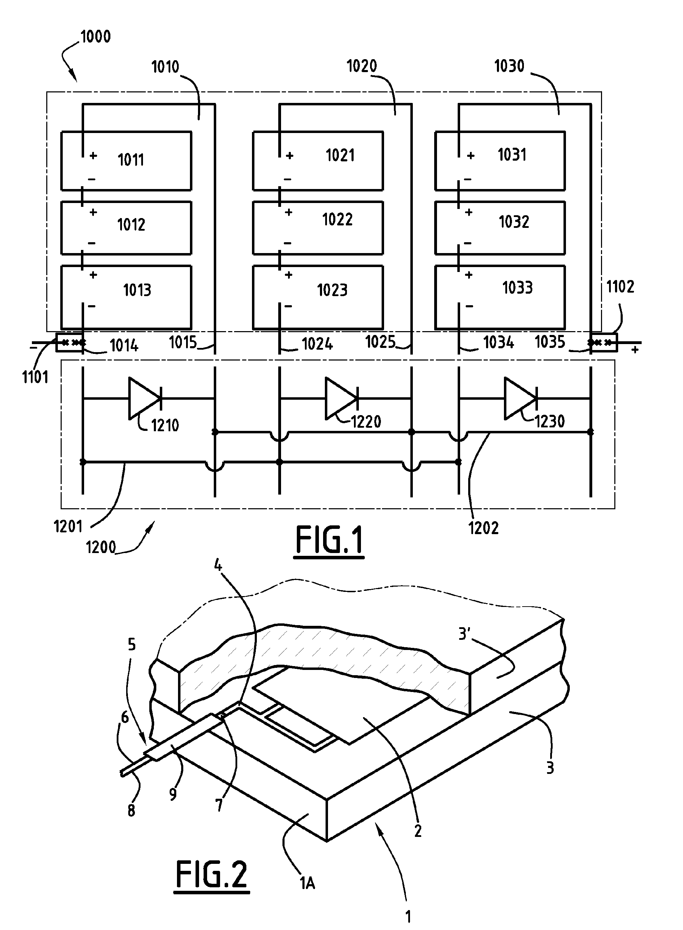

On va tout d'abord décrire le principe général d'un raccordement sur un circuit d'utilisation extérieur des générateurs d'électricité d'un panneau photovoltaïque. Pour cela, on va s'appuyer sur la figure 1.

Le panneau photovoltaïque, repéré généralement par 1000, comporte une pluralité de files, 1010, 1020, 1030 de cellules génératrices d'électricité repérées 1011, 1012, 1013 pour la file 1010, repérées 1021, 1022, 1023, pour la file 1020, et repérées 1031, 1032, 1033 pour la file 1030. Chacune des cellules génératrices d'électricité comporte un pôle positif et un pôle négatif. Dans chacune des files, 1010, 1020, 1030, les cellules génératrices d'électricité sont montées en série, de sorte que chaque file comporte une connexion à un pôle négatif et une connexion au pôle positif. Dans l'exemple représenté, la file 1010 a une connexion au pôle négatif 1014 et une connexion au pôle positif 1015, de même la file 1020 a une connexion au pôle négatif 1024 et une connexion au pôle positif 1025, et la file 1030 a une connexion au pôle négatif 1034 et une connexion au pôle positif 1035. L'ensemble des files est connecté en parallèle par l'intermédiaire d'un circuit de connexion 1200 qui comporte d'une part des connexions 1201 de connexion des pôles négatifs 1014, 1024 et 1034 à un pôle négatif du circuit d'utilisation 1101, et un circuit de connexion 1202 des pôles positifs 1015, 1025 et 1035 des files de cellules génératrices d'électricité à un connecteur commun extérieur positif 1102. En outre, le circuit d'interconnexion des files de cellules génératrices d'électricité comporte des diodes de bipassage 1210, 1220 et 1230 qui sont disposées entre le pôle négatif et le pôle positif de chacune des files de cellules génératrices d'électricité : entre la connexion négative 1014 et la connexion positive 1015 de la file de cellules génératrices d'électricité 1010, de la même façon entre le pôle négatif 1024 et le pôle positif 1025 de la file 1020, et entre le pôle négatif 1034 et le pôle positif 1035 de la file 1030. Chacune de ces diodes permet de by passer la file de cellules génératrices d'électricité correspondante, lorsque cette file est détériorée ou lorsque cette file est à l'ombre d'un nuage elle devient alors récepteur par rapport aux autre files de cellules.

Dans l'exemple qui vient d'être décrit, le panneau photovoltaïque comprend trois files de cellules génératrices d'électricité, chaque file comportant trois cellules génératrices d'électricité. Mais, l'homme du métier comprendra qu'un panneau photovoltaïque peut comprendre un nombre différent, et en particulier plus important de file de cellules génératrices d'électricité comprenant chacune un nombre différent, en particulier plus de trois cellules génératrices d'électricité. L'homme du métier comprendra également que d'autres branchements que ceux qui viennent d'être décrits sont possibles. En particulier, plusieurs files peuvent être connectées entre elles en série au lieu d'être en parallèle.

On va maintenant décrire un mode de réalisation d'un dispositif de connexion électrique externe d'un panneau photovoltaïque.

Le panneau photovoltaïque, repéré généralement par 1, comporte au moins une cellule génératrice d'électricité 2 enserrée et collée entre une plaque inférieure 3 et une plaque supérieure 3'. Chaque pôle de la cellule génératrice d'électricité 2 est connecté par des bandes de conduction 4 (une seule visible sur la figure) qui, pour celles qui sont destinées à être connectées vers l'extérieur du panneau, sont connectées à une bandelette de connexion externe repérée généralement par 5. La bandelette de connexion externe est constituée d'un ruban 6 en matériau conducteur tel que le cuivre, dont une partie de la surface est isolée par exemple par une couche d'émail 9, et dont une extrémité 7 est soudée sur les bandes conductrices 4 de façon à assurer une jonction électrique et dont l'extrémité 8 située vers l'extérieur du panneau, est nue, de façon à pouvoir assurer un contact électrique avec un moyen de connexion. La bandelette de connexion externe qui est disposée à l'interface entre les couches inférieure et supérieure du panneau photovoltaïque s'étend vers l'extérieur de la tranche 1 A de celui-ci.

Bien qu'une seule bandelette de connexion externe soit visible sur la figure, l'homme du métier comprendra qu'un panneau qui comprend une pluralité de files de cellules génératrices d'électricité peut comporter une bandelette de connexion externe pour le pôle positif de chaque file de cellules génératrices d'électricité et une bandelette de connexion externe pour le pôle négatif de chaque file de cellules génératrices d'électricité. Ainsi, un panneau photovoltaïque qui comporte trois files de cellules génératrices d'électricité peut comporter au moins quatre bandelettes de connexion externe s'étendant vers l'extérieur de la tranche du panneau photovoltaïque, selon le type de connexion choisi par le fabriquant de panneaux photovoltaïques et peut, par exemple, en comporter six comme représenté sur le dessin.

En effet, la mise en série, ou en parallèle, de files de cellules peut être réalisé à l'intérieur du panneau photovoltaïque, les diodes de by passage sont souvent insérées dans le panneau. Mais, et comme c'est le cas avec l'exemple décrit, chaque file (communément appelée « string ») peut être connectée aux autres à l'extérieur du panneau. Il y a alors six bandelettes de connexion.

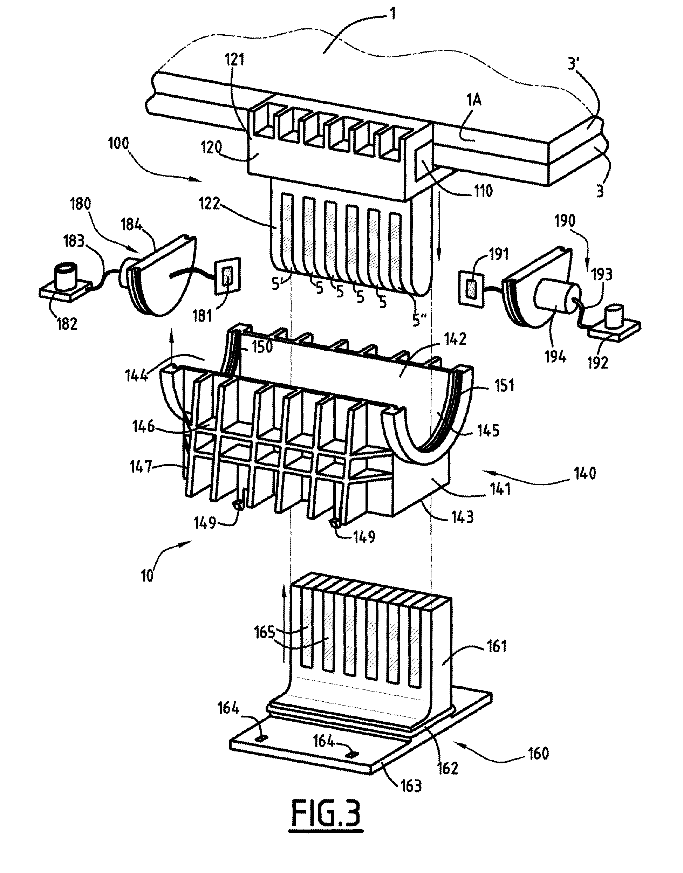

Afin d'assurer les interconnexions entre les différentes files de cellules génératrices d'électricité et la connexion vers l'extérieur du panneau photovoltaïque, les bandelettes de connexion externe qui viennent d'être décrites sont incorporées dans un ensemble qui constitue le dispositif de connexion externe des cellules génératrices d'électricité d'un panneau photovoltaïque que l'on va décrire maintenant et qui est représenté de façon éclatée à la figure 3.

Le dispositif de connexion électrique externe représenté à la figure 3 comprend un connecteur mâle repéré généralement par 100, fixé sur la tranche 1 A du panneau photovoltaïque 1, une barrette d'interconnexion électrique des bandelettes externes repérées généralement par 160, un premier contacteur extérieur comportant un moyen de jonction électrique avec les bandelettes de connexion externe relié à une première polarité de cellules génératrices d'électricité repérée généralement par 180, un deuxième connecteur extérieur comportant un moyen de jonction électrique avec une bandelette de connexion externe reliée à une deuxième polarité de cellules génératrices d'électricité repérées généralement par 190, et enfin un moyen de maintien et d'assemblage du connecteur mâle, de la barrette d'interconnexion, du premier et du deuxième connecteur externe. Ce moyen de maintien et d'assemblage est repéré généralement par 140.

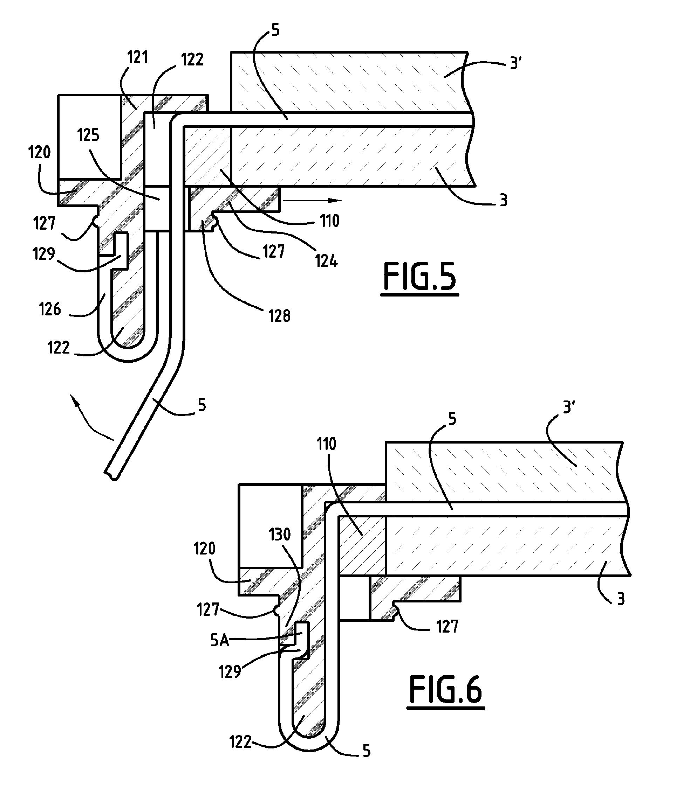

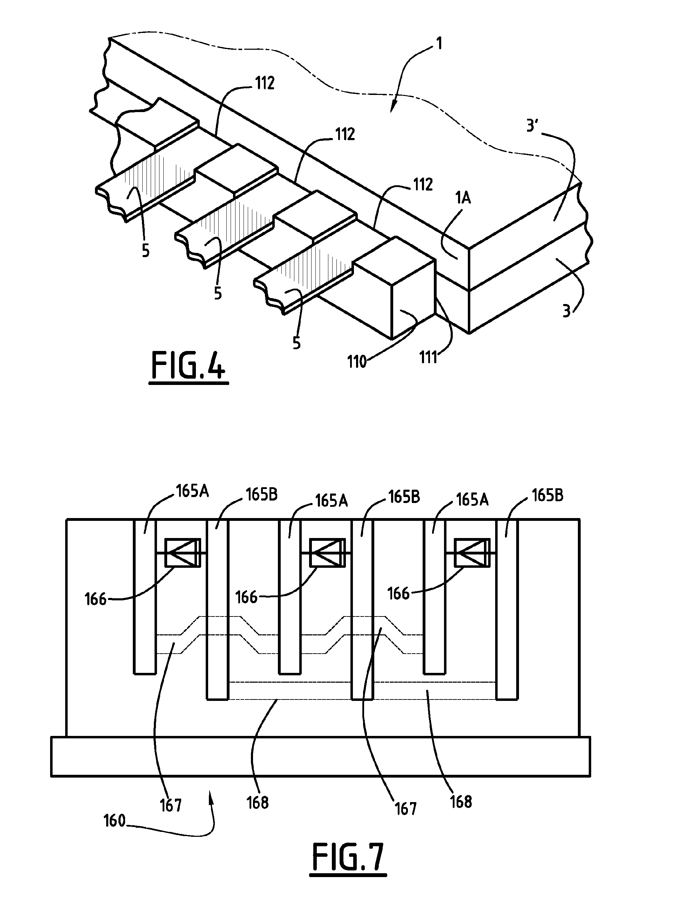

On va maintenant décrire le connecteur mâle repéré généralement par 100. Ce connecteur mâle comporte tout d'abord une entretoise 110 collée contre la tranche 1 A du panneau photovoltaïque. Comme cela est représenté à la figure 4, cette entretoise comporte des créneaux 112 qui servent à recevoir les bandelettes 5 qui sortent de la tranche 1A du panneau photovoltaïque. Cette entretoise 110 sert à maintenir une barrette support de bandelettes 120 (voir figures 3, 4; 5 6) qui comporte une tête de fixation 121 et une lame 122 s'étendant vers l'extérieur du panneau perpendiculairement à celui-ci. La lame 122 comporte des rainures 126 destinées à recevoir des bandelettes 5. La tête 120 de la barrette comporte une gorge 122 destinée à venir s'emboîter sur l'entretoise 110 collée sur la tranche du panneau photovoltaïque. La tête comporte également une lamelle 124 qui est destinée à venir au contact de la partie inférieure du panneau photovoltaïque. Cette lamelle inférieure 124 comporte une ouverture 125 destinée à laisser passer les bandelettes de connexion externe 5. Cette ouverture 125 est de dimension suffisante pour que, au moment du montage, les bandelettes 5 puissent passer à travers cette ouverture et que, après mise en place des bandelettes, la barrette puisse être mise définitivement en position en étant rapprochée de la tranche du panneau photovoltaïque, comme cela est représenté aux figures 5 et 6.

A la figure 6 en particulier, on voit que les bandelettes 5 sont disposées à l'intérieur des rainures et enroulées autour de la lame 122 destinée à supporter les bandelettes. L'extrémité de chaque bandelette étant reprise dans une cavité 129 située à la jonction entre la lame 122 et la tête support 121 de la barrette 120. Cette cavité 129 comporte des bords 130 qui peuvent être rabattus pour maintenir en position des bandelettes conductrices 5, 5', 5". Ces bordures peuvent être rabattues par exemple par ultrasons. Enfin, à la partie supérieure de la lame, le connecteur comporte une base 128 destinée à s'emboîter dans le manchon de maintien 140. Cette base 128 comporte un bourrelet 127 qui s'étend à sa périphérie et qui est destiné à assurer l'étanchéité lors du montage du connecteur mâle dans son support. On obtient ainsi un connecteur mâle qui comporte une lame de connexion s'étendant vers l'extérieur du panneau photovoltaïque et autour de laquelle les bandelettes conductrices sont enroulées et peuvent ainsi venir au contact de patins de connexion.

Comme on l'a représenté à la figure 3, le connecteur mâle est destiné à venir s'insérer dans un dispositif de maintien de l'ensemble repéré généralement par 140, qui est un manchon creux, ayant une ouverture supérieure 142 destinée à recevoir le connecteur mâle et une ouverture inférieure 143 dans laquelle sera insérée la barrette d'interconnexion électrique 160 qui sera décrite ultérieurement. Le manchon 140 comporte un corps 141 de forme généralement rectangulaire dont les deux extrémités comportent des échancrures de forme généralement en demi-cercle 144 et 145 qui seront destinée à recevoir les connecteurs externes 180 et 190. Les parois latérales 146 du manchon 140 sont renforcées par des nervures 147 et à leur partie inférieure, comportent des petits crochets 149 qui sont destinés à retenir la barrette d'interconnexion 160. Les échancrures semi circulaires 144 et 145 destinées à recevoir les connecteurs extérieurs comportent des gorges 150 et 151 dans lesquelles pourront s'insérer des joints associés aux connecteurs externes.

Comme on l'a indiqué, le dispositif de connexion électrique externe comporte deux connecteurs extérieurs repérés généralement par 180 et 190, le premier connecteur extérieur 180 comporte une palette de jonction électrique 181 qui est une plaque en matériau cuivreux qui peut être recouvert d'une pâte de brasage. Cette palette de jonction électrique est reliée par un conducteur électrique 183 à une cosse de connexion extérieure 182 qui est par exemple une cosse de connexion femelle. Le fil conducteur 183 passe à travers un manchon en matériau polymère souple 184 dont la forme est adaptée pour pouvoir s'emboîter dans l'échancrure 144 du manchon 140. Le bord du manchon en matériau polymère 184 est adapté pour pouvoir s'insérer dans la rainure 150 qui s'étend à la périphérie de l'échancrure 144 du manchon de maintien 140, de façon à assurer l'étanchéité. De la même façon, le deuxième connecteur extérieur 190 comporte une palette de jonction électrique 191 également en alliage cuivreux sur laquelle est déposée une pâte de brasage. La palette de jonction électrique est reliée à une cosse de connexion extérieure 192 qui est une cosse mâle par l'intermédiaire d'un conducteur électrique 193 qui passe à travers du manchon 194 en matériau polymère souple adapté pour pouvoir s'emboîter dans l'échancrure 145 du manchon de maintien 140. Le bord du manchon 194 est adapté pour s'insérer dans la rainure 151 qui s'étend à la périphérie d'échancrure 145 de façon à assurer une bonne étanchéité. On notera que lorsque le connecteur mâle 100 est emboîté dans le manchon de maintien 140 et que les connecteurs extérieurs 180 et 190 sont disposés dans le manchon de maintien 140, les palettes de jonction 181 et 191 viennent au contact des bandelettes 5' et 5" situées aux extrémités de la lame 122 du connecteur mâle 100. Lorsque les palettes de jonction 181 et 191 sont en contact des bandelettes de connexion, celles-ci peuvent être soudées par exemple en chauffant par induction depuis l'extérieur, ce chauffage par induction faisant fondre la pâte de brasage et assurant ainsi le brasage des palettes de jonction sur les bandelettes de connexion.

On peut aussi réaliser la connexion en utilisant des palettes de jonctions constituées de contacts à lamelles qui permettent de réaliser les connexions sans brasage.

Lorsque le connecteur mâle et les connecteurs extérieurs sont disposés dans le manchon de maintien 140, l'étanchéité du connecteur de l'ensemble est assuré d'une part par les manchons en matériau polymère souple 184 et 194 des connecteurs extérieurs, et d'autre part, par les bourrelets 127 qui se trouvent à la partie supérieure de la lame du connecteur mâle et qui viennent au contact de la périphérie de l'ouverture 142 du manchon de maintien 140. La forme de l'ouverture 142 du manchon 140 est adaptée pour qu'il y ait un bon ajustement du connecteur mâle dans le manchon de maintien 140 de façon à assurer une excellente étanchéité. En outre, pour conforter l'étanchéité, le connecteur mâle peut être collé sur la partie supérieure du manchon de maintien 140.

Comme on l'a indiqué plus haut, le dispositif de connexion électrique comprend également une barrette d'interconnexion électrique des bandelettes externes, repérée généralement par 160, qui comporte une lame centrale 161 comportant des patins de jonction 165 disposés de façon à venir au contact des bandelettes d'interconnexion 5, 5', 5" de la lame du connecteur mâle. Cette lame 161 de la barrette d'interconnexion électrique comporte à sa partie inférieure des bourrelets 162 d'étanchéité, et une embase 163 comportant des ouvertures 164. La barrette d'interconnexion électrique vient s'enficher dans l'ouverture 143 située à la partie inférieure du manchon de maintien 140, la lame 161 venant en regard de la lame 122 du connecteur mâle de telle sorte que les patins de jonction électrique 165 viennent au contact des bandelettes de connexion externes 5, 5' et 5".

De plus, les crochets 149 disposés à la partie inférieure du manchon de maintien 140 viennent s'encliqueter dans les trous 164 prévus dans la base 163 de la barrette d'interconnexion. Enfin, les bourrelets 162 situés à la base de la barrette d'interconnexion viennent en contact des parois latérales du manchon 140 et assurent ainsi l'étanchéité.

En outre, la barrette d'interconnexion comprend des circuits électriques d'interconnexion des différentes files de cellules génératrices d'électricité du panneau photovoltaïque, correspondant, par exemple, au schéma électrique représenté à la figure 1. Ces circuits électriques qui sont surmoulés à l'intérieur de la lame 161 peuvent comporter, comme cela est représenté à la figure 7, des diodes 166 qui assurent le bipassage entre les patins 165A et 165B qui sont connectés d'une part aux pôles négatif et positif respectivement des files de cellules génératrices d'électricité et d'autre part peut aussi contenir des interconnexions 167 entre les patins 165A venant au contact des pôles négatifs des files de cellules génératrices d'électricité, et des interconnexions 168 entre des patins 165B destinés à venir au contact des connecteurs des pôles positifs des files de cellules productrices d'électricité.

Cette barrette d'interconnexion est montée de façon amovible dans le manchon de maintien de façon à pouvoir être changée pour remplacer ces barrettes lorsque des composants tels que les diodes ont été détériorés.

Cette barrette de connexion permet de changer les diodes du module photovoltaïque sans qu'on puisse toucher par inadvertance les parties électriquement actives du module photovoltaïque.

Cette barrette d'interconnexion permet aussi de réaliser les différents types de connexions des files de cellules génératrices d'électricité à l'extérieur du module photovoltaïque, au gré de la décision du fabricant de modules photovoltaïques.

L'ensemble des pièces qui constituent ce dispositif de connexion d'un panneau photovoltaïque est, à l'exception des éléments conducteurs, constitué de pièces en matière plastique moulée. Cette matière plastique peut, éventuellement, être, choisies de façon à avoir une bonne conductibilité thermique.

Le dispositif de connexion externe qui vient d'être décrit, est fixé sur la tranche des panneaux photovoltaïques et peut être adapté pour pouvoir s'implanter par exemple dans le montant des cadres support des panneaux photovoltaïques. Il peut aussi être fixé sur le montant des cornières en aluminium utilisées actuellement.

Le dispositif de connexion externe qui vient d'être décrit, est fixé sur la tranche des panneaux photovoltaïques. Mais, il peut être adapté pour être utilisé en remplacement des dispositifs de connexion actuel des modules photovoltaïques pour lesquels les bandelettes de connexion débouchent sur la face arrière des panneaux photovoltaïques. L'homme du métier sait faire une telle adaptation.

Dans le mode de réalisation qui a été décrit, le dispositif d'interconnexion permet de connecter vers l'extérieur un panneau photovoltaïque comportant trois files de cellules génératrices d'électricité. Mais l'homme du métier comprendra qu'il peut adapter ce dispositif d'interconnexion à des panneaux photovoltaïques qui comportent un nombre plus important ou moins important de files de cellules photoélectriques.

Dans l'exemple qui vient d'être décrit, le connecteur est monté sur un panneau photovoltaïque dont les cellules actives sont des cellules génératrices d'électricité. Mais de tels connecteurs peuvent être montés sur tout type de panneau électriquement actif comportant des cellules électriquement actives.

Dans ce cas le dispositif électriquement actif peut être un générateur tel que des cellules photovoltaïques ou un récepteur électrique tel qu'un panneau d'écran de cristaux liquides (LCD), de panneaux organiques électroluminescents, de panneaux de visualisation tels que des écrans plasma.

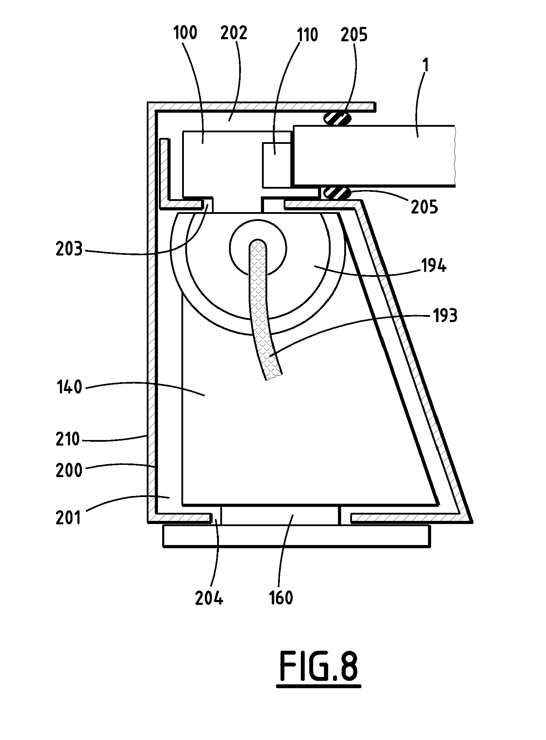

De tels panneaux électriquement actifs 1 sont montés dans des cadres 200 rectangulaires comprenant quatre montants creux 210 , 211, 212, 213. Chaque montant dont la section a, par exemple, la forme visible à la figure 8, comporte une partie tubulaire creuse 201 de section trapézoïdale, surmontée par une gorge 202 destinée à recevoir le bord du panneau électriquement actif 1.

De tels montants peuvent être fabriqués par divers procédés connus de l'homme du métier, mais de préférence par pliage d'une bande métallique d'épaisseur adaptée pour obtenir une rigidité et une résistance mécanique suffisantes. Ces bandes sont, de préférence, en acier inoxydable, mais tout matériau adapté connu de l'homme du métier peut être utilisé. En général, les montants sont fabriqués séparément et assemblés par exemple par soudage, de façon à constituer un cadre. Cependant, notamment lorsque les montants sont fabriqués par pliage de bandes métalliques, deux, trois ou quatre montants peuvent être réalisés par pliage d'une seule bande découpée préalablement de façon adaptée.

Les connecteurs selon l'invention sont disposés dans les montants de façon à être maintenus et protégés tout en permettant des connexions électriques à la fois à l'intérieur des parties creuses du cadre et vers l'extérieur pour connecter les cellules actives 2 du panneau et pour connecter les panneau entre eux ou avec un circuit 7 d'utilisation.

Comme représenté à la figure 8, un dispositif de connexion d'un panneau photovoltaïque est inséré dans le montant 210 d'un cadre 200 qui reçoit dans une gorge 202, la bordure du panneau photovoltaïque 1.

Le dispositif de connexion comprend, conformément à ce qui a été décrit ci-dessus, un connecteur mâle 100, une barrette d'interconnexion 160, des connecteurs extérieurs et un moyen de maintien 140 du connecteur male 100, de la barrette d'interconnexion 160 et des connecteurs extérieurs (sur la figure on ne voit que le manchon 194 d'un seul connecteur extérieur).

Le moyen de maintient 140 est un manchon creux disposé à l'intérieur 201 de la partie tubulaire du montant 210 du cadre 200, en regard, d'une part d'une ouverture 203 ménagée dans la partie supérieure de la partie tubulaire du montant 201, et d'une couverture 204 ménagée dans la partie inférieure de la partie tubulaire du montant 201.

Le connecteur mâle 100 qui est monté sur la tranche du panneau photovoltaïque 1, par l'intermédiaire d'une entretoise 110, pénètre à l'intérieur de la partie creuse 201 du montant 210 en passant à travers l'ouverture supérieure 203 et, ainsi, vient s'insérer à l'intérieur du manchon creux 140.

De la même façon, la barrette d'interconnexion 160 pénètre à l'intérieur de la partie creuse 201 du montant 210 en passant par l'ouverture inférieure 204 et, ainsi, vient s'insérer à l'intérieur du manchon creux 140 de maintien.

Avec cette disposition, il est possible de changer les diodes de by passage, par exemple pour réparer le dispositif, sans risque de toucher par inadvertance les parties électriquement actives des modules photovoltaïques.

Enfin, les manchons des conducteurs électriques de liaison avec les cosses de connexion extérieure sont reçus dans la partie creuse (seul le manchon 194 et le conducteur 193 sont visibles sur la figure 8).

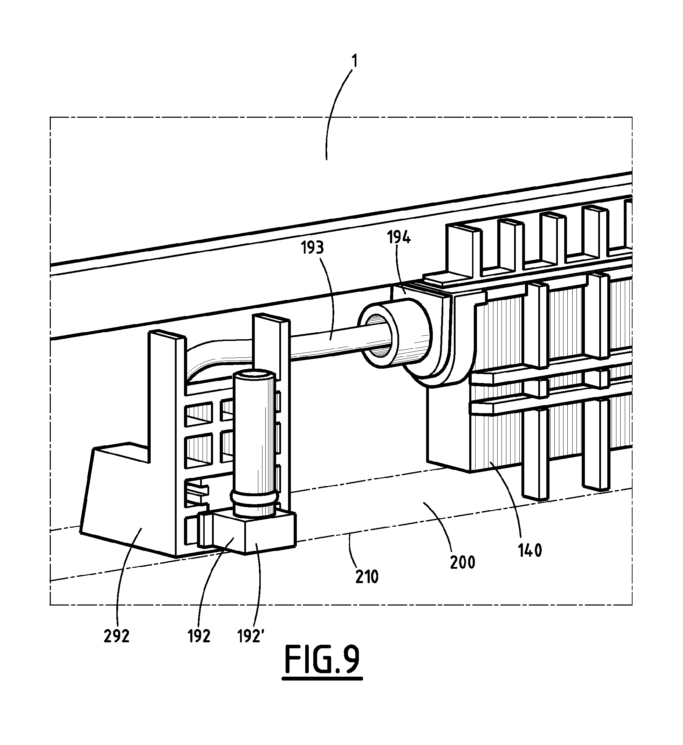

Comme on le voit à la figure 9, un connecteur externe du type mâle, comprend un conducteur 193 qui sort du manchon creux de maintien 140 à travers le manchon souple 194 qui relie une palette de fonction électrique (non visible sur la figure 9) disposée à l'intérieur du manchon creux de maintien 140 et une cosse de connexion extérieure 192 mâle.

Le cosse de connexion extérieure qui s'étend à l'extérieur du montant 210 du cadre 200 comporte une embase 192' qui passe à travers une ouverture prévue dans la paroi latérale du montant 210, et qui vient coopérer avec une entretoise de maintien 292, disposée à l'intérieur du montant 201. Dans le cas représenté, la cosse mâle est orientée vers le haut.

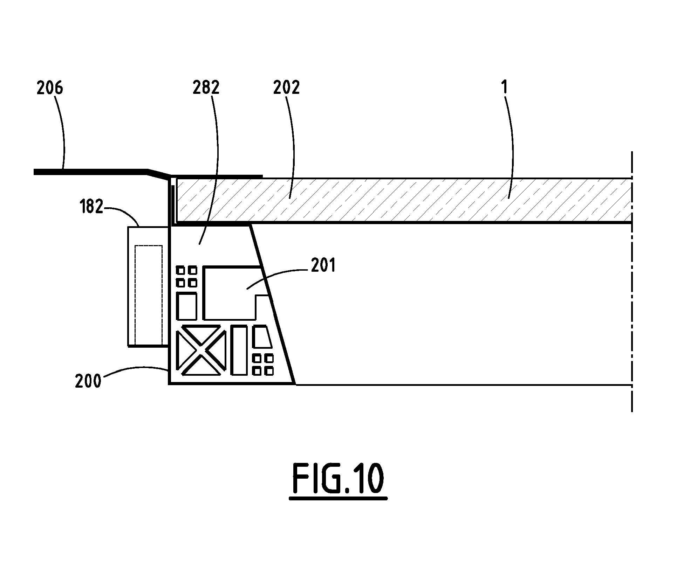

Comme représenté à la figure 10, une cosse femelle 182 s'étend à l'extérieur du montant pour coopérer avec une entretoise de maintien 282 et avec un conducteur électrique (non visible sur la figure).

Cette cosse femelle est orientée vers le bas de façon à pouvoir coopérer avec une cosse mâle d'un cadre adjacent et ainsi permettre l'interconnexion de panneaux adjacents.

On notera que du côté de cette cosse orientée vers le bas, le montant du cadre comporte, à sa partie supérieure, une aile 206 qui s'étend vers l'extérieur et qui permet d'assurer l'étanchéité à la jonction entre deux panneaux adjacents.

Dans le second mode de réalisation décrit, la cosse mâle est orientée vers le haut et la cosse femelle vers le bas, mais la disposition inverse est possible.

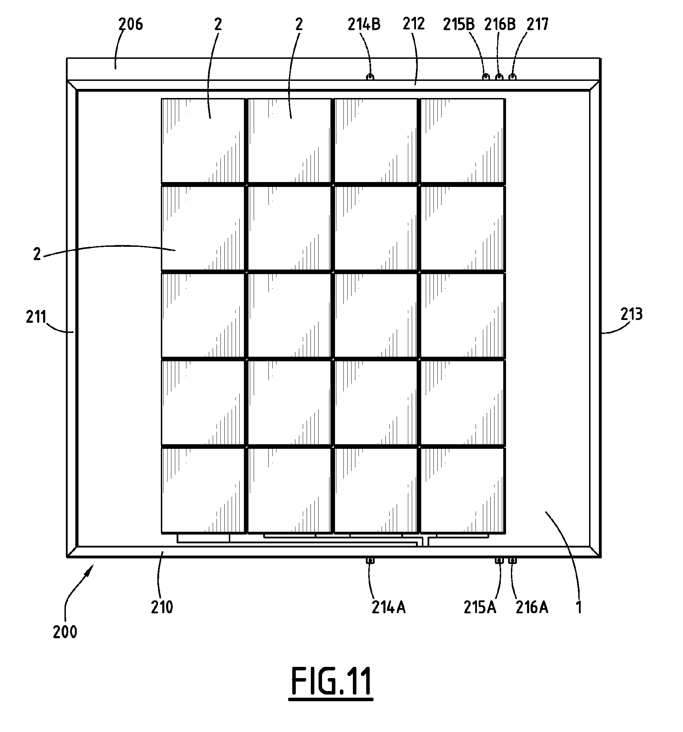

Comme on peut le voir sur la figure 11, le cadre 200 qui supporte le panneau 1 de cellules photovoltaïques 2, comporte des connecteurs extérieurs mâles 214A, 215A, 216A situés sur un premier montant 210 qui contient le dispositif de connexion électrique externe (non visible sur la figure) des cellules photovoltaïques, et des connecteurs extérieurs femelles 214B, 215B, 216B et 217, situés sur un deuxième montant 212 du cadre, situé à l'opposé du premier montant 210. Les connecteurs mâles 214A, 215A et 216A, et les connecteurs femelles 214B, 215B et 216C sont disposés de façon à être en regard les uns des autres deux à deux.

Ainsi, lorsque deux cadres sont disposés l'un au-dessus de l'autre, les connecteurs mâles de l'un peuvent coopérer avec les connecteurs femelles de l'autre.

En outre, les connecteurs mâles et femelles sont reliés soit au dispositif de connexion externe soit entre eux, selon leur destination, par l'intermédiaire de conducteurs électriques qui sont reçus dans les parties creuses du cadre 200. Ainsi, les conducteurs électriques sont à la fois protégés et dissimulés.

Le nombre de connecteurs extérieurs ainsi que les liaisons électriques entre eux peuvent être adaptés en fonction des besoins propres à chaque application et l'homme du métier sait déterminer les connexions adaptées.

En particulier, il est possible de prévoir des montages en série ou des montages en parallèles des panneaux.

En outre, il est possible de prévoir des connexions pour les circuits de retour. Ces connexions comprendront, pour chaque cadre, un connecteur extérieur mâle et un connecteur extérieur femelle directement reliés par un conducteur électrique disposé à l'intérieur des montants du cadre.

La fabrication du cadre par pliage de bandes métalliques selon des lignes de pliage horizontales a l'avantage de permettre d'insérer facilement les connecteurs et plus généralement les circuits électriques. En effet, les connecteurs, les entretoises support et les conducteurs électriques d'interconnexion entre connecteurs, peuvent être mis en place sur les bandes métalliques prédécoupées destinées à réaliser les montants du cadre, lorsqu'elles ne sont que partiellement pliées. Lorsque les différentes pièces qui constituent le dispositif de connexion, sont en place, on peut terminer le pliage des bandes métalliques et l'assemblage du cadre. De la sorte, les moyens de connexion, sauf les cosses qui doivent s'étendre à l'extérieur des montants, sont entièrement contenus à l'intérieur des montants. Ainsi ces moyens de connexion sont à la fois dissimulés et protégés.

A titre d'exemple, on a illustré partiellement différentes phases de fabrication d'un cadre contenant des connecteurs.

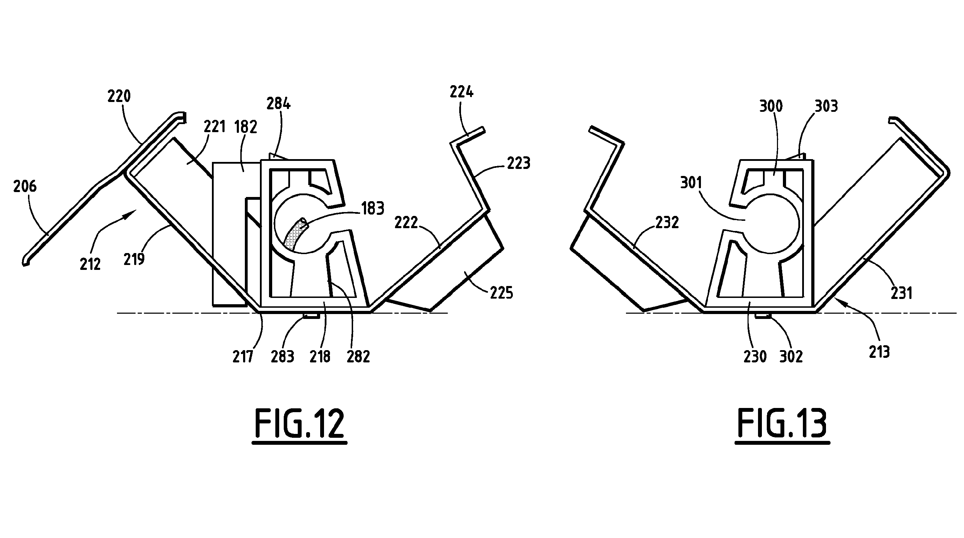

A la figure 12 on a représenté en coupe un montant 210 recevant un connecteur extérieur femelle 182 dans une première phase de fabrication.

Le montant 210 est constitué d'une bande métallique qui a été pliée partiellement de façon à lui donner une certaine rigidité tout en constituant une structure ouverte.

Ce montant comprend un fond 217 percé d'un trou 218 destiné à recevoir un plot 283 de fixation de l'entretoise 282 qui supporte la cosse femelle 182 du connecteur femelle extérieur.

Le montant 212 comprend également une face latérale extérieure 219 et une face latérale intérieure 222.

La face latérale extérieure 219 porte une aile extérieure 206, une aile intérieure 220 et une patte de jonction 221. L'aile extérieure 206 est destinée à assurer l'étanchéité à la jonction entre deux cadres adjacents. L'aile intérieure 220 est destinée à venir recouvrir le bord du panneau photovoltaïque maintenu dans le cadre.

La patte 221 sert à assurer la jonction entre deux montants adjacents.

La face latérale intérieure 222 se prolonge par une aile 223 comportant un rebord 224, qui sont destinées à former la paroi supérieure de la partie tubulaire du montant et ainsi constituer la face inférieure de la gorge destinée à recevoir le bord du panneau photovoltaïque. Le rebord 224 est adapté pour pouvoir être soudé sur la face latérale extérieure 219 en fin de montage du montant. La face latérale intérieure 222 est en outre prolongée par au moins une patte de jonction 225 qui sert à assurer la jonctions avec un montant adjacent.

Tel qu'il est représenté à la figure 12, le montant est ouvert ce qui permet de disposer à l'intérieur une entretoise 282 qui porte une cosse femelle de connexion extérieure 182.

L'entretoise 282 qui est en matière plastique comporte à sa partie inférieure un plot de fixation 283 qui est inséré dans le trou 218 de la face inférieure 217 du montant. A sa partie supérieure, l'entretoise 282 comporte un ergot 284 qui permet de retenir la face latérale intérieure 222 par clipsage de l'aile 223.

La face latérale extérieure 219 comporte une ouverture non visible sur la figure, permettant le passage de la cosse de connexion extérieure.

Avec cette disposition il est aisé d'implanter une cosse de connexion extérieure femelle sur la bande métallique destinée à constituer un montant puis à enfermer cette cosse de connexion à l'extérieur du montant en terminant le pliage des faces latérales du montant comme cela sera décrit plus loin.

La description qui vient d'être faite concerne la mise en place d'une cosse de connexion extérieure femelle. Mais, l'homme du métier comprendra que la mise en place des cosses de connexion extérieure mâles, la mise en place du manchon de maintien de l'assemblage du connecteur mâle et de la barrette d'interconnexion du dispositif de connexion externe, ainsi que des entretoises de maintien des conducteurs électriques de liaison, se fait de la même façon, c'est à dire sur des bandes métalliques partiellement pliées afin de constituer des structures ouvertes.

A titre d'exemple, on a représenté à la figure 13, une entretoise 300 qui est implantée par exemple dans le montant 213 disposé entre les montants 210 et 212 qui portent les dispositifs de connexion.

L'entretoise 300 qui est uniquement destinée à retenir les conducteurs électriques de liaison comporte une ouverture centrale 301 destinée à recevoir les conducteurs électriques, un plot de fixation 302 sur sa face inférieure et un ergot 303 de clipsage des ailes du montant 213, sur sa face supérieure.

Le montant 211 comporte un fond 230 encadré par une face latérale extérieure 231 et une face latérale intérieure 232. Le montant se distingue de celui qui a été décrit précédemment uniquement par le fait qu'il ne comporte pas d'aile extérieure destinée à assurer l'étanchéité à la jonction entre deux cadres adjacents, ni d'ouverture pour laisser passer de la cosse de connexion extérieure.

Lorsque les moyens de connexion et les entretoises de maintien des conducteurs électriques de liaison sont disposés sur les bandes métalliques destinées à constituer les montants du cadre, on dispose ces bandes côte à côte dans une disposition correspondant au cadre déplié et on met en place les conducteurs électriques de jonction pour constituer les circuits électriques internes du cadre.

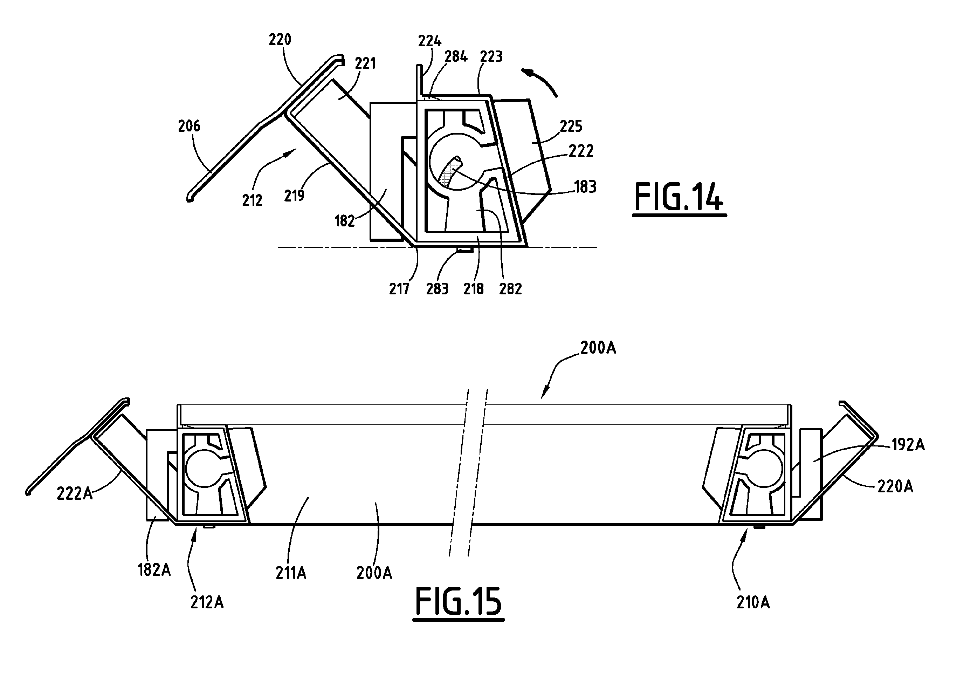

Une fois les circuits internes constitués, on finit le pliage des faces latérales internes des montants de façon à envelopper les dispositifs de connexion ou les entretoises disposées sur les bandes métalliques destinées à constituer les montants et ainsi, à clipser les faces latérales internes sur les ergots de clipsage. A titre d'exemple, à la figure 14, on a représenté le montant 212 sur lequel est disposée une cosse de connexion extérieure femelle 182 portée par l'entretoise 282. Sur cette figure on voit que la face latérale interne 222 du montant est complètement pliée et qu'elle enveloppe l'entretoise 282 sur laquelle elle est maintenue par clipsage par l'intermédiaire de l'ergot 284. En revanche, la face latérale externe 219 est encore en position ouverte.

On replie alors les quatre montants pour constituer un cadre rectangulaire qu'on assemble en soudant les pattes de fixation telle que la patte de fixation 225 prévues sur les faces latérales internes des montants adjacents.

On obtient ainsi un cadre 200 A, tel que représenté à la Fig. 15, dont les faces latérales extérieures des montants sont en position d'ouverture, écartées vers l'extérieur. Sur la figure 15, on voit les faces latérales 220A et 222A des montants 210A et 212A en position ouverte. Sur la figure 15, on voit également des cosses de connexion extérieure femelle 182A et mâle 192A. L'homme du métier comprendra que tous les moyens de connexion que doit comporter le cadre sont en place et que toutes les faces latérales extérieures sont en position ouverte, écartées vers l'extérieur.

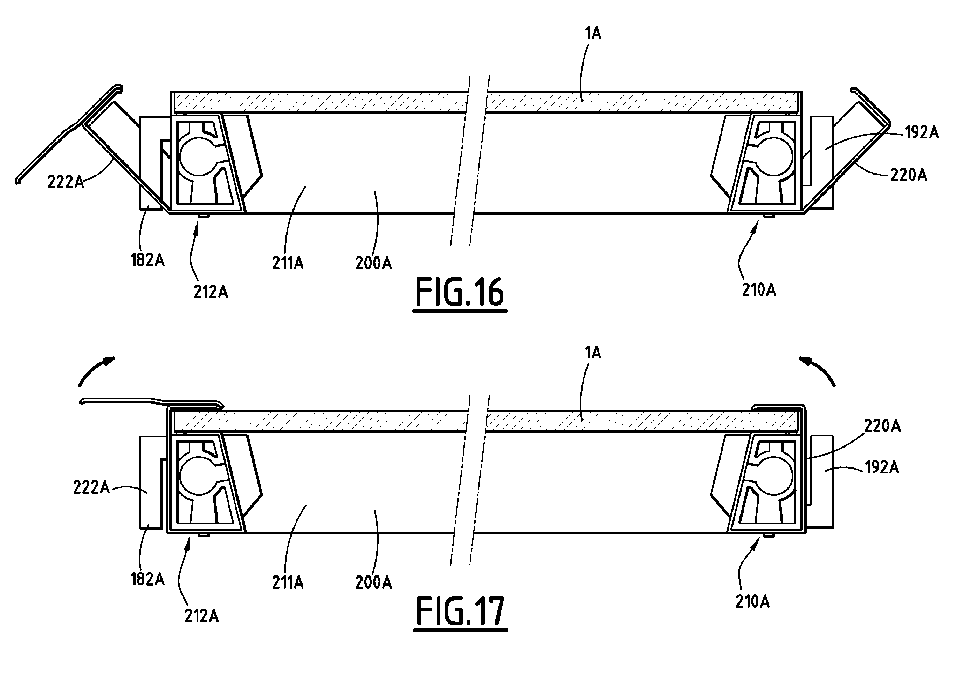

Lorsque le cadre est dans la disposition qui vient d'être décrite il est possible de disposer un panneau photovoltaïque 1 A sur les montants du cadre 200A, comme on le voit sur la figure 16 (sur cette figure, on ne voit que trois montants 210A, 211A, 212A, mais on comprendra que le panneau photovoltaïque repose également sur le quatrième montant qui n'est pas visible sur la figure).

Une fois que le panneau photovoltaïque est disposé sur le montant du cadre, il est possible de poursuivre le montage en repliant les faces latérales extérieures, notamment les faces latérales extérieures 220A, 222A visibles sur la figure, vers l'intérieur du cadre comme cela est représenté sur la figure 17, et en terminant en soudant notamment les pattes de fixation des faces latérales extérieures des montants sur les montants adjacents, ainsi que les quatre coins supérieurs et inférieurs des montants 210, 211, 212, 213.

Le panneau photovoltaïque est ainsi monté sur un cadre qui incorpore les moyens de connexion dans ses montants tubulaires.

## Revendications

1. Dispositif de connexion électrique externe des cellules électriquement actives d'un panneau électriquement actif telles que les cellules génératrices d'électricité (2) d'un panneau photovoltaïque (1), **caractérisé en ce qu'**il comprend :
- un connecteur mâle (100) disposé sur la tranche du panneau photovoltaïque (1), comportant une pluralité de bandelettes de connexion externes (5, 5', 5") reliées électriquement aux cellules génératrices d'électricité,
- une barrette d'interconnexion électrique des bandelettes externes (160), comportant des moyens de jonction électrique (165, 165A, 165B) avec les bandelettes de connexion externe, reliés entre eux par des circuits électriques (166, 167, 168) adaptés à l'interconnexion des cellules génératrices d'électricité,
- un premier connecteur extérieur (180) comportant un moyen (181) de jonction électrique avec une bandelette de connexion externe reliée à une première polarité des cellules génératrices d'électricité,
- un deuxième connecteur extérieur (190) comportant un moyen (191) de jonction électrique avec une bandelette de connexion externe reliée à une deuxième polarité de cellules génératrices d'électricité, et
- un moyen de maintien (140) de l'assemblage du connecteur mâle (100), de la barrette d'interconnexion (160), du premier (180) et du deuxième (190) connecteur externe.

2. Dispositif selon la revendication 1, **caractérisé en ce que** le connecteur mâle (100) comprend une barrette support (120) des bandelettes de connexion externe comportant une lame (122) s'étendant à l'extérieur du panneau photovoltaïque, et **en ce que** les bandelettes (5, 5', 5") de connexion externe sont enroulées autour de la lame (122).

3. Dispositif selon la revendication 2, **caractérisé en ce que** le connecteur mâle (100) comprend, en outre, une entretoise (110) comportant des créneaux (112) destinés à recevoir les bandelettes (5) de connexion externe, et **en ce que** la barrette support (120) comprend une tête (121) adaptée pour s'emboîter sur l'entretoise (110).

4. Dispositif selon la revendication 3, **caractérisé en ce que** l'entretoise (110) est collée sur la tranche (1 A) du panneau photovoltaïque (1).

5. Dispositif selon l'une quelconque des revendications 2 à 4, **caractérisé en ce que** la lame (122) s'étend à l'extérieur du panneau photovoltaïque, perpendiculairement à la surface du panneau photovoltaïque.

6. Dispositif selon l'une quelconque des revendications 2 à 5, **caractérisé en ce que** le moyen de maintien de l'assemblage est un manchon de maintien creux (140) comportant une ouverture supérieure (142) dans laquelle la barrette support des bandelettes de connexion externe (120) est emmanchée et **en ce que** la périphérie de l'ouverture supérieure (142) et de la partie (128) de barrette (120) destinée à s'emboîter dans l'ouverture supérieure sont conformés de façon à assurer l'étanchéité de la jonction du manchon de maintien (140) et de la barrette support (120).

7. Dispositif selon la revendication 6, **caractérisé en ce que** la barrette support (120) comporte un bourrelet périphérique (127) destiné à assurer l'étanchéité de la jonction avec le manchon de maintien (140).

8. Dispositif selon la revendication 6 ou la revendication 7, **caractérisé en ce que** le manchon de maintien (140) et la barrette support (120) sont collés entre eux.

9. Dispositif selon l'une quelconque des revendications 6 à 8, **caractérisé en ce que** le manchon de maintien (140) comporte à chacune de ses extrémités un passage pour un connecteur extérieur (144, 145).

10. Dispositif selon la revendication 9, **caractérisé en ce que** le passage pour un connecteur extérieur (144, 145) est une échancrure dont la périphérie comporte une gorge (150, 151).

11. Dispositif selon la revendication 9 ou la revendication 10, **caractérisé en ce que** chaque connecteur extérieur (180, 190) comporte une palette de jonction électrique avec une bandelette de connexion externe (181, 191), reliée électriquement à une cosse de connexion extérieure (182, 192), et un manchon en matériau polymère souple (184, 194) adapté pour s'emboîter dans le passage pour connecteur extérieur (144, 145) du manchon de maintien (140) de façon à constituer une fermeture étanche du passage.

12. Dispositif selon la revendication 11, **caractérisé en ce que** la cosse de connexion extérieure (192) d'un connecteur extérieur (190) est une cosse mâle et la cosse de connexion extérieur (182) de l'autre connecteur extérieur (180) est une cosse femelle.

13. Dispositif selon la revendication 11 ou la revendication 12, **caractérisé en ce que** la palette de jonction (181, 191) d'au moins un connecteur extérieur est soudée par brasage sur une bandelette de connexion externe (5', 5").

14. Dispositif selon la revendication 11 ou la revendication 12, **caractérisé en ce que** la palette de jonction (181, 191) d'au moins un connecteur extérieur est connectée par compression de contacts à lamelles sur une bandelette de connexion externe (5', 5").

15. Dispositif selon l'une quelconque des revendications 6 à 14, **caractérisé en ce que** la barrette d'interconnexion électrique (160) comprend une lame (161) comportant des patins de jonction électrique avec les bandelettes externes (165, 165A, 165B), enfichable de façon réversible dans une ouverture inférieure (143) du manchon creux de maintien (140).

16. Dispositif la revendication 15, **caractérisé en ce que** la périphérie de l'ouverture inférieure (143) du manchon de maintien et la partie de la barrette d'interconnexion (160) destinée à s'emboîter dans le manchon de maintien (140) sont conformés de façon à assurer l'étanchéité de la jonction du manchon de maintien et de la barrette d'interconnexion.

17. Dispositif selon l'une quelconque des revendications précédentes, **caractérisée en ce que** le connecteur mâle (100), la barrette d'interconnexion (160) et le moyen de maintien de l'assemblage (140) comportent au moins une pièce en matière plastique.

18. Dispositif selon l'une quelconque des revendications 1 à 17, **caractérisé en ce que** les circuits électriques adaptés pour l'interconnexion des cellules comportent des diodes (166) de by passage et des connexions (167, 168) de mise en parallèle ou en série de cellules génératrices d'électricité.

19. Dispositif selon la revendication 1, **caractérisé en ce que** les bandelettes de connexion externes (5) sont des rubans conducteurs (6) partiellement isolés par des couches d'isolation telles que des couches d'émail (9).

20. Panneau électriquement actif (1) tel qu'un panneau photovoltaïque monté dans un cadre support (200) comprenant quatre montants creux (210, 211, 212, 213) tubulaires et des moyens de connexion externe du panneau électriquement actif, **caractérisé en ce** les moyens de connexion externe (100, 140, 160, 180, 190) sont selon l'une quelconque des revendications 1 à 19 et sont disposés à l'intérieur des parties tubulaires creuses (201) des montants du cadre support (200).

21. Panneau électriquement actif monté dans un cadre support selon la revendication 20, **caractérisé en ce que** le moyen de connexion externe comprend au moins une cosse de connexion extérieure mâle et une cosse de connexion extérieure femelle s'étendant à l'extérieur du cadre et disposés de telle sorte que les panneaux électriquement actifs de deux cadres adjacents peuvent être connectés entre eux par emboîtement d'une cosse mâle d'un cadre et d'une cosse femelle de l'autre cadre.

22. Panneau électriquement actif monté dans un cadre selon la revendication 20 ou la revendication 21, **caractérisé en ce que** le cadre est constitué d'au moins une bande métallique découpée, et mise en forme par pliage.

23. Panneau électriquement actif monté dans un cadre selon l'une quelconque des revendications 20 à 22, **caractérisé en ce que** le cadre est constitué de quatre montants séparés assemblés entre eux.
